# EUROPEAN PATENT APPLICATION

(11) **EP 3 686 941 A1**
(43) Date of publication of application: **29.07.2020**
(21) Application number: 19153747.1
(22) Date of filing: 25.01.2019
(51) Int. Cl.: H01L 41/047

(54) **METHOD FOR PRODUCING A LAYERED ELECTRONIC DEVICE AND LAYERED ELECTRONIC DEVICE**

(71) Applicant: Robert Bosch GmbH, 70442 Stuttgart (DE)
(72) Inventor: Jeon, Jin Han, 558962 Singapore (SG); Fook, Tony, 751589 Singapur (SG)

(57) **Abstract**

A layered electronic device, for example a haptic feedback device and a method for producing a layered electronic device are disclosed. The layered electronic device may include a plurality of electrodes. The plurality of electrodes may include at least a target electrode. The method may include providing a processing tool. The processing tool may include a film providing a pressing surface for pressing the target electrode against a layer underneath the target electrode. The film may include a film compressive yield strength. The method may further include processing the target electrode by at least pressing the pressing surface against the target electrode. The film compressive yield strength may be higher than a compressive yield strength of the layer underneath the target electrode.

## Description

### TECHNICAL FIELD

The present disclosure relates to a method for producing a layered electronic device and to a layered electronic device produced by such method.

### BACKGROUND

Conventional electronic devices may have electrically active layers between electrodes. The methods for producing the electrodes may be very complex due to the requirements of the electrodes, for example of high conductivity and low roughness. Especially for transparent electrodes, the deposition of transparent metal oxides (e.g. ITO) may require complex control of many parameters.

Therefore, there is a need to provide for improved electrodes which are easier to produce.

### SUMMARY

It is therefore, object of the invention to provide an improved method for producing a layered electronic device, for example a haptic feedback actuator.

Various embodiments relate to a method for producing a layered electronic device, for example a haptic feedback actuator. The layered electronic device may include a plurality of electrodes. The plurality of electrodes may include at least a target electrode. The method may include providing a processing tool. The processing tool may include a film providing a pressing surface for pressing the target electrode against a layer underneath the target electrode. The film may include a film compressive yield strength. The method may further include processing the target electrode by at least pressing the pressing surface against the target electrode. The film compressive yield strength may be higher than a compressive yield strength of the layer underneath the target electrode.

According to various embodiments, the method may further include providing a substrate. The method may further include depositing a first electrode of the plurality of electrodes on the substrate, for example, in a first electrode depositing step. The method may further include depositing an active layer on the first electrode, for example in an active layer depositing step, wherein the active layer is a first active layer. The method may include depositing a second electrode of the plurality of electrodes on the first active layer, for example, in an electrode depositing step.

Various embodiments relate to a layered electronic device, for example a haptic feedback device.

### BRIEF DESCRIPTION OF THE DRAWINGS

In the following description, various embodiments of the present disclosure are described with reference to the following drawings, in which:
FIG. 1 shows a schematic illustration of a cross section of a layered electronic device 100. The inset (a) shows an enlarged view of a portion of the layered electronic device 100 in accordance with various embodiments, and inset (b) shows a comparative example;
FIG. 2 shows a schematic illustration of a method 200 for producing a layered electronic device 100;
FIG. 3 shows an SEM image of an electrode including AgNWs on a poly (vinylidenefluoride - trifluoroethylene -chlorotrifluoroethylene) (abbreviated as P(VDF-TrFE-CTFE) layer, after heat treatment at 150°C for 20 min;
FIG. 4 shows an SEM image of an electrode including AgNWs on a P(VDF-TrFE-CTFE) layer after mechanically pressing at 50 MPa for 10 seconds at room temperature;
FIG. 5 shows an SEM image of an electrode including AgNWs on a P(VDF-TrFE-CTFE) layer after pressing at 90 MPa for 10 seconds at room temperature. The AgNWs are embedded into the polymer layer.

### DETAILED DESCRIPTION

The following detailed description describes specific details and embodiments in which the invention may be practiced. These embodiments are described in sufficient detail to enable those skilled in the art to practice the invention. Other embodiments may be utilized and changes may be made without departing from the scope of the invention. The various embodiments are not necessarily mutually exclusive, as some embodiments can be combined with one or more other embodiments to form new embodiments.

Features that are described in the context of an embodiment may correspondingly be applicable to the same or similar features in the other embodiments. Features that are described in the context of an embodiment may correspondingly be applicable to the other embodiments, even if not explicitly described in these other embodiments. Furthermore, additions and/or combinations and/or alternatives as described for a feature in the context of an embodiment may correspondingly be applicable to the same or similar feature in the other embodiments.

The invention illustratively described herein may suitably be practiced in the absence of any element or elements, limitation or limitations, not specifically disclosed herein. Thus, for example, the terms "comprising", "including," containing", etc. shall be read expansively and without limitation. The word "comprise" or variations such as "comprises" or "comprising" will accordingly be understood to imply the inclusion of a stated integer or groups of integers but not the exclusion of any other integer or group of integers. Additionally, the terms and expressions employed herein have been used as terms of description and not of limitation, and there is no intention in the use of such terms and expressions of excluding any equivalents of the features shown and described or portions thereof, but it is recognized that various modifications are possible within the scope of the invention claimed. Thus, it should be understood that although the present invention has been specifically disclosed by exemplary embodiments and optional features, modification and variation of the inventions embodied herein disclosed may be resorted to by those skilled in the art, and that such modifications and variations are considered to be within the scope of this invention.

As used herein, the term "and/or" includes any and all combinations of one or more of the associated listed items.

As used herein, the term "film" refers to the film included in the processing tool. Accordingly, the expression "film compressive yield" refers to the compressive yield of the film included in the processing tool. How to determine the compressive yield will be explained in more details further below.

The reference signs included in parenthesis in the claims are for ease of understanding of the invention and have no limiting effect on the scope of the claims.

Within the context of the present disclosure and in accordance with various embodiments a reference to an (n)-th electrode means an electrode with an index n. For example, when n=1, the (n)-th electrode is the first electrode, and when n=2, the (n)-th electrode is the second electrode. Similarly, when a reference is made to an (n+1)-th electrode, for the example of n=1 reference is made to the (1+1)-th electrode, thus to the second electrode, and so on for integer n's greater than zero. In some embodiments, the top most electrode may be referred to as (m+1)-th electrode, wherein m is the total number of active layers. The total number of active layers required for a device may be pre-defined before the method is started, for example in a device specification.

Within the context of the present disclosure and in according to various embodiments, a reference to an (n)-th active layer means an active layer with an index n. For example, when n=1, the (n)-th active layer is the first active layer, and when n=2, the (n)-th active layer is the second active layer. Similarly, when a reference is made to an (n+1)-th active layer, for the example of n=1 reference is made to the (1+1)-th active layer, thus to the second active layer, and so on for integer n's greater than zero.

Within the context of the present disclosure and in according to various embodiments, it is to be understood that each of the electrodes is formed by a respective electrode layer, even if in most embodiments no explicit reference is made to the respective electrode's "layer".

The method according to various embodiments may use facile mechanical pressing of electrodes, which may be transparent conductive electrodes, to at least partially embed them into the substrate (e.g. a flexible polymer substrate) or active layers to create an ultra-low interfacial surface roughness in the produced layered electronic devices. With little to no penetration of electrodes into the active layer, a high voltage corresponding to an electric field close to that of the intrinsic breakdown field of the polymer can be applied without electric breakdown (shorting) leading to improved actuation performance. Consequently it is possible to make thinner active layers. Haptic actuators including the layered electronic devices produced based on the disclosed method demonstrate high actuation performance without breaking down, eliminating the need for thick active layers to increase electric breakdown voltage. Furthermore, using thin active layers also saves cost and improves optical properties and device flexibility.

The method according to various embodiments, has following advantages:
- High compatibility with standard layer coating processes, for example doctor blade, rod coating, bar coating, screen printing, slot die coating, spin coating, roll to roll (R2R) coating and others;
- Patterning of electrodes and/or active layer(s) is possible and independent of the processes step of electrode processing, thus not affecting the roughness of the electrodes after electrode processing;
- Flexibility in producing various haptic actuator designs (e.g. complex array or multi-stacked structures) and up-scaling;
- High resistance to electric breakdown in layered electronic devices fabricated due to minimal interfacial roughness;
- Improved actuation performance due to high allowed applied voltage / electric field without electric breakdown;
- Improved optical properties and device flexibility by the use of thin active layers made possible with low interfacial roughness;
- The time needed to at least partially embed an electrodes into an underlying layer is short at a few seconds (e.g. less than 60 seconds) compared to lengthy conventional heat treatments which are in the range of tens of minutes to hours; and
- A single step of mechanically pressing electrode into polymer layers may be used to eliminate complex, tedious and time consuming procedure that includes multiple steps to create electrode embedded polymer film.

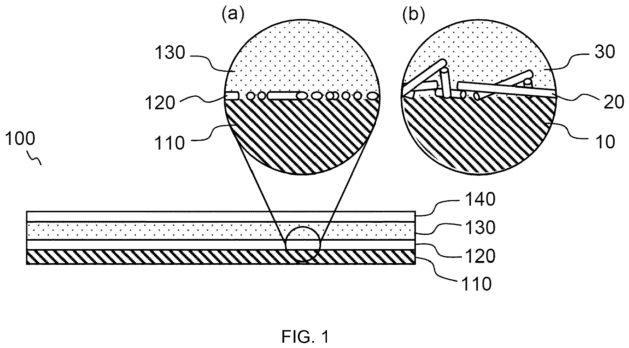

FIG. 1 shows a schematic illustration of a cross section of a layered electronic device 100. The inset (a) shows an enlarged view of a portion of the layered electronic device 100 in accordance with various embodiments. Inset (b) shows a comparative example.

FIG. 1 is a schematic illustration of a layered structure of a layered electronic device 100. The layered electronic device 100 may include a first electrode 120 disposed on a substrate 110. The layered electronic device 100 may further include an active layer 130 disposed on the first electrode 120. The layered electronic device 100 may further include a second electrode 140 disposed on the active layer 130.

Although the first electrode 120 and second electrode 140 are shown as layers in FIG. 1, they do not necessarily form compact closed layers. For example, the electrode depositing step may include depositing a composition including elongated particles (e.g. nanowires) dispersed in a solvent, wherein the solvent is removed (e.g. via evaporation) from the layer. In such case, the remaining layer of elongated particles could form a network of particles, which may be sufficiently thick to allow for lateral (e.g., along the layer's may surface) conduction of electricity.

In FIG. 1, inset (a) shows an enlarged view of the schematic illustration of the interface between the substrate 110 and the active layer 130. Layer 120 includes elongated nanoparticles which are confined in a narrow space between layers 110 and 130. The confinement may be reached by flattening electrode 130 as will be explained further below. The flattening of the electrode 130 may reduce the roughness of the layer. The roughness may also be lowered by embedding at least partially the elongate nanowires in the substrate 110. FIG. 1, inset (a) shows an example between the first electrode 130 in between substrate 110 and active layer 130, however, the same structure and methods may apply to additional layers, for example, to a second electrode (140) between a first active layer 130 and a second active layer.

In FIG. 1, inset (b) shows an enlarged view of a schematic illustration of an interface between a substrate 10 and an active layer 30 of a comparative example, wherein the elongated nanoparticles of layer 20 were deposited over the substrate 10 and wherein an active layer 30 was deposited over the active layer 30, without any electrode processing. Thus, it can be seen that the interfacial roughness is high and local height spikes are present. Local height spikes of the electrode may cause undesired electric breakdown where the distance between two electrodes is low.

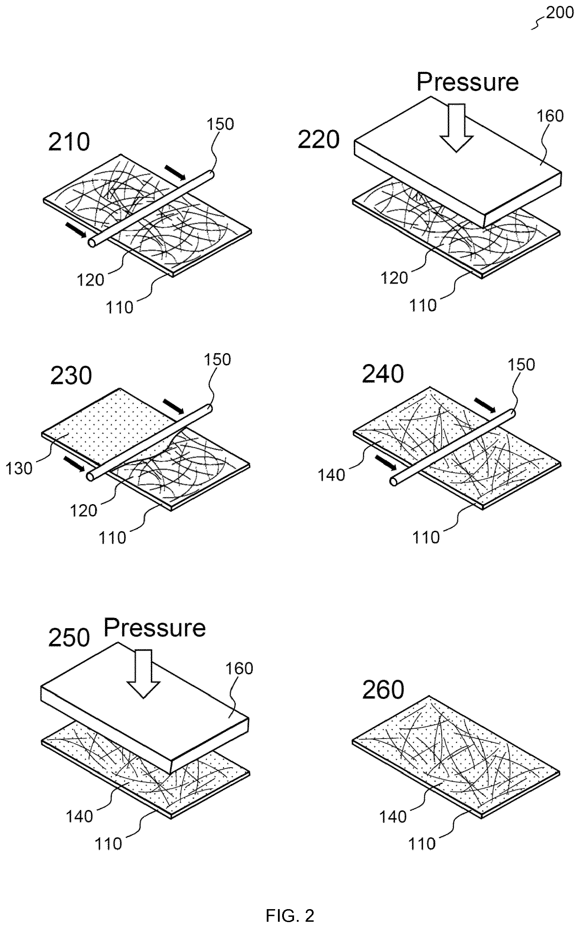

The detailed description of the production procedure is shown in connection with FIG. 2. FIG. 2 shows a schematic illustration of a method 200 for producing a layered electronic device 100 in accordance with various embodiments. The method 200 may include a step of providing a substrate 110.

### Substrate

According to various embodiments, the substrate may be a flexible substrate.

According to various embodiments, the substrate may be a transparent substrate.

According to various embodiments, the substrate may be a polymer substrate, for as polyethylene terephthalate (PET), polyethylene naphthalate (PEN), polycarbonate (PC), which may be flexible and/or transparent.

According to various embodiments, the layered electronic device, for example the haptic feedback device, may be a transparent device. Further, the layered electronic device may be a flexible device.

According to various embodiments, prior to the first electrode depositing, a surface treatment may be applied on the substrate. The surface treatment may be, for example, a plasma treatment such as O₂ or Ar, or another surface treatment to induce hydroxyl (-OH) groups on the surface through surface modification to enhance the adhesion and bonding properties between the bottom electrode and substrate. Alternatively or in addition, an interfacial overcoat layer may be applied on the substrate to enhance the adhesion and bonding properties between the first electrode and the substrate. It means that induced hydrophilicity also helps in better binding between hydrophilic first electrode (e.g. bar or spray coated AgNWs) and substrate.

### Electrode

The following explanation refers to an electrode, and may be applied to any (n)-th electrode. When n=1 then the first electrode is deposited on the substrate, when n>1 then then (n)-th electrode is deposited on the underneath (n)-th active layer.

The method 200 may include depositing an electrode, for example, depositing a first electrode 120 in a first electrode depositing step 210. As illustrated by way of example, the first electrode may include elongated nanoparticles, for example metal nanostructures such as silver nanowires (AgNWs), other metal nanowires, nanogrids or combinations thereof. According to various embodiments, at least one of the (n)-th electrodes may include elongated particles. The elongated particles may be, for example, nanowires, nanogrids, metal nanostructures such as silver nanowires (AgNWs), other metal nanowires, metal nanogrids or combinations thereof.

In the example of FIG. 2, Meyer rod coating may be adopted for depositing the first electrode, wherein a rod 150 is used for forming the layer of the first electrode 120. The first electrode may be transparent. Meyer rod coating may be adopted due to its fast speed and ease of use. However, other known coating techniques may be used, for example, bar coating, spray coating, screen printing. The electrode may be either patterned or non-patterned.

The term "plurality of electrodes", if not otherwise explicitly mentioned, may, herein, include the first electrode or any other electrode, for example the second electrode or a third electrode. Consequently the term "(n)-th electrode", if not otherwise explicitly mentioned, may, herein, refer to any electrode of the plurality of electrodes.

The expression "target electrode", as used herein may refer to the at least one of the plurality of electrodes, which is processed during the method according to various embodiments.

### Electrode Processing

The following explanation refers to the processing of an (n)-th electrode, and may be applied to any (n)-th electrode. When n=1 then the first electrode may have an interface with the substrate and the first active layer, when n>1 then the (n)-th electrode may have an interface with (n)-th active layer, and may further have an interface with an (n+1) active layer, if provided.

According to various embodiments, an underlying layer, also referred to as a layer underneath an electrode, may refer to the substrate layer when the electrode (the target electrode) is the first electrode, or may refer to the active layer which is most proximal to (closest to) the electrode (the target electrode) and which is between the substrate and the electrode when the electrode is an electrode other than the first electrode. The first electrode is the electrode proximal to the substrate.

According to various embodiments, the processing tool may be a press and the pressing surface may be a press die surface.

According to various embodiments, for applying a pressure on an electrode, e.g. by pressing on an electrode, the pre-formed layered electronic device may be held on a respective support, for example during processing the target electrode the pre-formed layered electronic device may rest on a respective substrate holder, on a workbench, or other suitable support.

According to various embodiments, processing may include pressing the pressing surface against the target electrode, wherein the film compressive yield strength is higher than the compressive yield strength of a layer underneath the target electrode. For example, the film compressive yield strength may be at least 10 MPa, for example at least 20 MPa, higher than the compressive yield strength of a layer underneath the target electrode.

According to various embodiments, the film compressive yield strength may be higher than the compressive yield strength of the substrate. For example, the film compressive yield strength may be at least 10 MPa, for example at least 20 MPa, higher than the compressive yield strength of the substrate.

According to various embodiments, the film compressive yield strength may be higher than the compressive yield strength of the active layer, for example, of the top most (further away from the substrate) active layer. For example, the film compressive yield strength may be at least 10 MPa, for example at least 20 MPa, higher than the compressive yield strength of the top most (further away from the substrate) active layer.

According to various embodiments, the processing tool comprises a film providing a pressing surface. For example, the film may be a top protective layer on a press die. The film may have a higher compressive yield strength than the compressive yield strength of a layer underneath the target electrode. Thereby the nanowires may be embedded into the layer underneath instead of the film layer. For example, the film compressive yield strength may be equal or higher than 150 MPa.

According to various embodiments, the film may be of polyetherimide (PEI). For example, when a film of PEI, with a compressive yield strength of 150 MPa, may be used to process an electrode on a substrate of PET, with a compressive yield strength of 80 MPa.

The compressive yield strength of the top protective layer and the layer underneath may be measured under same conditions, for example in accordance with ASTM D695, for example at a relative humidity of 50 ±10% and at a temperature of 23 ± 2 °C or a at higher temperature for the compressive yield strength at a high temperature as will be explained further below. The compressive yield strength may be determined at the offset compressive yield strength on the stress-strain curve. One exemplary test procedure is described as follows: the specimen is placed between compressive plates parallel to the surface. The specimen is then compressed at a uniform rate. The maximum load is recorded along with stress-strain data. An extensometer attached to the front of the fixture is used to determine modulus. For materials that do not rupture, it is possible to report the results as compressive strength at specific deformation such as 5% samples' original height (percent compressive strain).

According to various embodiments, the method may further include heating the layer underneath the electrode, for example the substrate. In one example the complete pre-formed layered electronic device may be heated, thus heating all the layers. Heating may facilitate the at least partial embedding of elongated nanoparticles of the electrode into the layer underneath the electrode. The polymer may be heated to above its glass transition temperature. This may soften the material while mechanically pressing the electrodes into the polymer (hot-pressing) which may be an advantage, for example for polymers with high compressive yield strength. E.g. for most commercially available PET substrates, metal nanowires may be embedded into the polymer at a pressure, for example, between 80 MPa and 100 MPa when softened by heating to a temperature of or above 150 °C and, for example, below the melt point.

According to various embodiments, heating and pressing may be performed simultaneous, e.g. in a single step. Thus, the electrode and device properties may be improved in a single step.

According to various embodiments, the surface used to press electrodes into an underneath layer, for example a pressing surface, may have a surface roughness equal or lower to that of the substrate to retain minimal surface roughness after embedding the electrode into the polymer. The surface used to press the electrodes, for example the pressing surface may be of a film included in the processing tool, for example on the press. The film may be used for its low surface roughness, equal or lowers than the roughness of the layer underneath the target electrode.

According to various embodiments, the compressive yield strength may be adjusted, for example, by heating. For example, the compressive yield strength of the substrate may be lowered by heating the substrate. In another example, the compressive yield strength of an active layer may be lowered by heating the active layer. The heating can be up to just below the melting point of substrate, for example to under 260 °C for a substrate including PET (with melt point at 260 °C), to under 225 °C for a substrate including PC (with melt point at 225 °C), to under 270 °C for a substrate including PEN (with melt point 270 °C). With heating, it is possible to adjust the compressive yield strength. When the top protective layer has a compressive yield strength equal of higher to the layer underneath the target electrode, for example equal of higher to the compressive yield strength of the substrate in case of the processing the bottom electrode, heating may provide a lowering of the compressive yield strength. A suitable film (e.g. top protection layer) with a compressive yield strength higher than the compressive yield strength of the layer underneath the target electrode, at a temperature above 23 °C and below the melting point of the film, may be employed.

According to various embodiments, for processing the bottom electrode, the film compressive yield strength at a high temperature may be higher than the compressive yield strength of the substrate at the high temperature, wherein the high temperature is above 23 °C and below the melting point of the film. The high temperature may be below the melting point of the substrate.

According to various embodiments, for processing of the top most electrode (further away from the substrate), the film compressive yield strength at a high temperature may be higher than the compressive yield strength of the active layer, for example, of the top most (further away from the substrate) active layer, at the high temperature, wherein the high temperature is above 23 °C and below the melting point of the film. The high temperature may be below the melting point of the substrate.

According to various embodiments, the target electrode may be the first electrode and the layer underneath may be the substrate, and processing the target electrode may include embedding the nanoparticles of the first electrode at least partially in the substrate. Processing the first electrode as target electrode may be carried out before depositing the active layer. According to various embodiments, the target electrode may be the second electrode and the layer underneath may be the active layer, and processing the target electrode may include embedding the nanoparticles of the second electrode at least partially in the active layer. Processing the second electrode as target electrode may be carried out after depositing the second electrode. For example processing the first electrode, for example in an electrode processing step, may include embedding the elongated particles of the first electrode at least partially into the substrate. For example, as illustrated by means of example in FIG. 2, in an electrode processing step 220, the electrode, for example the first electrode 120, may be treated with mechanical pressing, thus reducing an electrode roughness. For processing the electrode, for example the first electrode or any other electrode, mechanical pressing with a press 160 may be used for its high time efficiency as it may simultaneously flatten the electrode and embed the electrode at least partially into the underlying layer (in this example, the substrate) in a single process. However, any pressing technique that is able to obtain at least an electrode with reduced roughness, for example flattened and/or at least partially embedded into the underlying layer (in this example, the substrate), may be used. While the electrode processing step is explained above in connection to the first electrode, the electrode processing step may apply to any other electrode of the layered electronic device.

According to various embodiments, weld the nanoparticles may refer to joining at least some of the nanoparticles of an electrode, for example the contacts between two nanoparticles may be at least partially fused together. Thereby, reducing the contact resistance between the nanoparticles. Consequently, the conductivity of the electrode layer is significantly enhanced.

For mechanical pressing, the pressure to be applied to at least partially embed the electrode into the underneath layer may be adjusted by the skilled artisan according to his needs. For example, a higher pressure or operational temperature may be used for underneath layers of higher compressive yield strength (for example due to higher degree of crystallinity).

A suitable pressure range is from 10 MPa to 150 MPa, for example from 80 MPa to 100 MPa, during at least 5 seconds, e.g. at least 10 seconds, without heating (for example between 10 °C and 40 °C, e.g. at 23 °C), to weld the nanoparticles (for example metal nanowires) thereby increasing the conductivity of the electrode. Heating may be applied during pressing, for example heating to a temperature range from 40 °C to just below the polymer melting temperature, to embed the nanowires in the layer underneath the electrode.

According to various embodiments, the pressure may be applied for a time (processing time) of 5 seconds or more, for example less than 60 seconds.

For electrodes with high effective contact area with the underneath layer, for example, highly concentrated AgNWs, a higher pressure may be required for embedding into the underneath layer, for example equal or higher than 80 MPa. For nanowires (for example metal nanowires such as AgNW) on an electroactive material layer (for example a layer including electroactive piezoelectric polymers such as P(VDF-TrFE-CTFE) the pressure used for mechanical pressing without heating (for example between 10 °C and 40 °C, e.g. at 23 °C) may be selected, for example, between 10 MPa and 150 MPa, for example between 80 MPa and 100 MPa, for example for a duration of 10 seconds. The nanowire layer may be coated by Meyer rod coating, for example using a RDS 5 sized rod, e.g. over an AgNW dispersion of concentration 0.5 wt% in deionized water.

### Active Layer

For depositing an active layer, for example, in an active layer depositing step 230, the active layer, for example the first active layer 130, may be deposited on the underlying electrode, which for the example of FIG. 2 with the first active layer 130, is the first electrode 120. The active layer may be deposited, for example coated, using any conventional layer coating techniques, such as, for example, doctor blade, rod coating, bar coating, screen printing, slot die coating, spin coating, roll to roll (R2R) coating and others. FIG. 2 illustrates by way of example, rod coating, with rod 150. Rod 150 may be the same or different from the one used in step 210. The active layer may be patterned or non-patterned.

According to various embodiments, the method may include a post-process step wherein the electroactive layer is dried and/or annealed. Annealing may reinforce the crystalline structure, and may further reinforce the ferroelectric properties, for example for FerroEAP.

In accordance with various embodiments, the active layer may include or may be an electroactive layer. The term "electroactive layer" may mean a layer which may undergo a shape change in response to an applied electrical field, which layer may further emit an electrical signal upon mechanical stimulation. The electrical signal may be detected via electrodes coupled to the layer. The electroactive layer may include an electroactive material, e.g. an electroactive polymer. Within the context of the present disclosure and in accordance with various embodiments, an electroactive material, e.g., an electroactive polymer (EAP), is a material (a polymer in case of EAP) that undergoes shape change in response to an applied electrical field. Examples of electroactive materials may include: dielectric EAP (dEAP), piezo electric active polymer (piezoEAP). Examples of piezoEAPs are: FerroEAPs such as poly (vinylidenefluoride - trifluoroethylene - chlorotrifluoroethylene) abbreviated as P(VDF-TrFE-CTFE), poly(vinylidenefluoride-trifluoroethylene-chlorofluoroethylene) abbreviated as P(VDF-TrFE-CFE), poly(vinylidenefluoride - trifluoroethylene - hexafluoropropylene) abbreviated as P(VDF-TrFE-HFP), and poly[(vinylidenefluoride - co - trifluoroethylene] abbreviated as P(VDF-TrFE), poly[(vinylidenefluoride - co - hexafluoropropylene] abbreviated as P(VDF-HFP), poly[(vinylidenefluoride - co - chlorotrifluoroethylene] abbreviated as P(VDF-CTFE).

Examples of dielectric EAPs are: acrylic elastomers, silicon elastomers, fluoroelastomers, polyurethane, natural/synthetic rubbers.

### Second Electrode and Multiple Active Layers

According to various embodiments, the method may include depositing a second electrode, for example in an electrode depositing step, which may be carried out as described above in connection with the first electrode (as example). The second electrode may be deposited on the first active layer 130, for example, forming a layered electronic device with a single active layer, i.e. one active layer, between the first electrode and the second electrode.

In case an electrode is deposited from solution, the solvent may be chosen to avoid dissolving the underneath layer, for example de-ionised water and isopropyl alcohol can be used to disperse silver nanowires and does not dissolve PVDF and its co- and terpolymers. On the other hand, solvents for dissolving PVDF and its co- and terpolymers include but are not limited to methyl ethyl ketone, acetone, methyl iso-butyl ketone, cyclohexanone. For example for depositing the second electrode from a solvent containing solution, the solvent may be chosen so that it does not affect the underlying active layer, for example to avoid destroying the crystallinity achieved by a previous annealing process.

According to various embodiments, the second or further electrode may be made in accordance with the electrode section above. The second or further electrode may be either patterned or non-patterned.

According to various embodiments, the electrode processing step may be repeated for the second electrode or further electrode to flatten the electrode and embed the electrode at least partially into the underlying layer. For example, mechanical pressing may be used for all electrodes. For PVDF based piezoelectric polymers/copolymers, the electrodes may be pressed at room temperature at moderate pressure of 90 MPa due to its low mechanical properties owing to its low glass transition temperature.

According to various embodiments, the method may include repeating the steps of: (i) electrode processing, wherein the electrode is an (n+1)-th electrode; (ii) active layer depositing, wherein the active layer is an (n+1)-th active layer which is deposited on the (n)-th electrode; and (iii) electrode depositing, wherein the electrode is an (n+2)-th electrode which is deposited on the (n+1)-th active layer; for each integer n between 1 to m-1, wherein the total number of active layers (m) may be equal or greater than 2. For example, for multi-layer actuator designs, after step 230 (as shown in FIG. 2), steps 240, and 250 may be repeated multiple times.

According to various embodiments, the top most electrode may also be subject to further comprising repeating the step of electrode processing, wherein the electrode is the (m+1)-th electrode (140).

According to various embodiments, the method may further include forming an encapsulation. For example a protective insulation layer may be coated on top of the topmost electrode for protection, for example for electrically insulating the device from a user touching the device.

### Examples

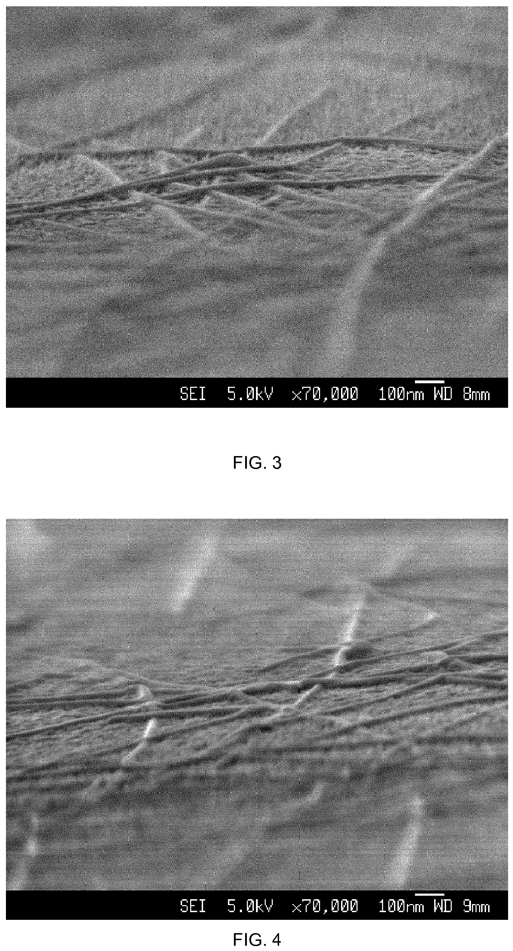

Figure 3 shows a scanning electron microscope (SEM) image of an electrode of silver nanowires (AgNWs) on an active layer after heat treatment at 150°C for 20 min. When employing conventional heat treatment for elongated nanoparticles, gaps exist between the AgNWs and the surface of the active layer which creates a rough surface which would lead to penetration of the conductive electrode into any layer coated on top of it, for example an active layer. Points of high penetration into the active layer act as sites for local electric breakdown (shorting) and limits the allowed applied voltage of the actuator device, thus heavily affecting the actuation performance of layered electronic devices. When carrying out the step of electrode processing, for example mechanically pressing elongated nanoparticles at moderate pressure, the gaps between the elongated nanoparticles and the active layer are eliminated as the elongated nanoparticles are pressed to be in contact with the electroactive layer as exemplary shown in Figure 4. Also, there is improved contact between the elongated nanoparticles, leading to higher conductivity due to reduced contact resistance. However, the surface roughness in this case can be further improved by flattening the electrode, for example by at least partially embedding the elongated nanoparticles in the polymer layer.

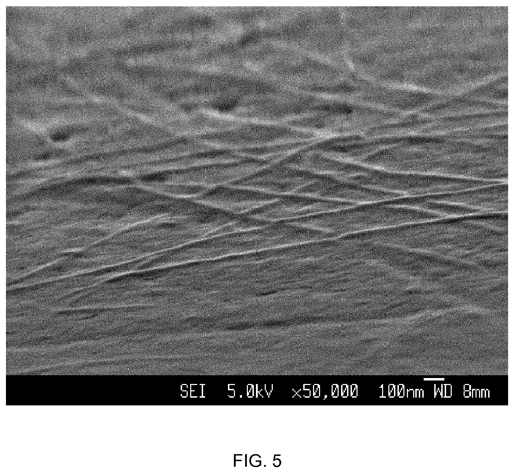

By mechanically pressing the elongated nanoparticles against active layer at a higher pressure, they can be embedded in the active layer as shown in Figure 5. While the conductivity improves considerably by pressing at moderate pressures ranging from 20 to 70 MPa for a AgNW network electrode layer coated by Meyer rod coating using a RDS 5 sized rod over a AgNW dispersion of concentration 0.5 wt% in DI water. The surface roughness is drastically reduced when pressing at higher pressure ranging from 80 to 100 MPa. In the example shown in FIG. 5, by pressing AgNWs into an active layer to form a semi-embedded structure, an RMS surface roughness of 4.4 nm, close to that of the un-modified active layer was achieved. The sheet resistance, optical transmissivity at 550nm and haze were measured to be 50Ω/□, 88% and 1.7% respectively. For comparison, the optical transmissivity and haze of the un-modified active layer 90% and 0.8% respectively. By heating the layer underneath the electrode, in this example the active layer, and mechanical pressing, for example through hot-pressing process, further improvement in terms of optical and electrical properties can be possible due to welding of metal nanomaterials as well as their moderate embedding into the substrate or active layer.

Similar experiments were carried out for metal nanowires on substrate obtaining the similar positive results. In one case an AgNW was deposited and processed as explained above, with the exception that the underlying layer was a PET substrate. The electrode AgNW electrode could be improved in the same manner by pressing. In another similar example, the at least partially produced layered electronic device was further heated at 150 °C while pressing, causing an embedding of the electrode into the PET substrate.

The present disclosure presents a facile, cost and time efficient production technique for layered devices, in particular for flexible and transparent piezoelectric, such as ferroelectric, polymer actuators with interfacial embedded silver nanowires for haptic applications. The proposed method may be employed in actuators with patterned or non-patterned electrodes and/or active layers as well as multi active layer designs. For multi active layer actuators, every active layer may be sandwiched between two electrodes. By employing the production method proposed in the present disclosure, the interfacial roughness of the interface between the substrate, active layer and the electrode in-between are drastically reduced. All other interfaces above active layers may have an ultra-low surface roughness as well.

## Claims

1. A method for producing a layered electronic device (100) comprising a plurality of electrodes (120, 140), wherein at least one of the plurality of electrodes (120, 140) is a target electrode, the method comprising:
- providing a processing tool comprising a film providing a pressing surface for pressing the target electrode against a layer underneath the target electrode, wherein the film comprises a film compressive yield strength;
- processing the target electrode by at least pressing the pressing surface against the target electrode, wherein the film compressive yield strength is higher than a compressive yield strength of the layer underneath the target electrode.

2. The method of claim 1, further comprising:
- providing a substrate (110);
- depositing a first electrode (120) of the plurality of electrodes (120, 140) on the substrate (110);
- depositing an active layer (130) on the first electrode (120);
- depositing a second electrode (140) of the plurality of electrodes (120, 140) on the active layer (130);
wherein the target electrode comprises nanoparticles.

3. The method of claim 2, wherein the target electrode is the first electrode (120) and the layer underneath is the substrate, wherein processing the target electrode is carried out before depositing the active layer (130), and wherein processing the target electrode comprises embedding the nanoparticles of the first electrode (120) at least partially in the substrate (110).

4. The method of claim 2, wherein the target electrode is the second electrode (120) and the layer underneath is the active layer (130) and wherein processing the target electrode comprises embedding the nanoparticles of the second electrode (120) at least partially in the active layer (130).

5. The method of any one of claims 2 to 4, wherein the active layer (130) is a first active layer, the plurality of electrodes comprises a third electrode, and the method further comprises:
- depositing a second active layer on the second electrode (140); and
- depositing the third electrode on the second active layer.

6. The method of any one of claims 1 to 5, wherein the processing tool is a press and the pressing surface is a press die surface.

7. The method of any one of claims 1 to 6, wherein a pressure applied by the pressing surface is selected from 10 MPa to 150 MPa.

8. The method of any one of claims 1 to 7, further comprising heating the at least partially produced layered electronic device.

9. The method of any one of claims 1 to 8, wherein heating is applied during pressing the tool surface against the target electrode.

10. The method of any one of claims 1 to 9, wherein the surface of the pressing surface has a roughness lower than the roughness of the layer underneath.

11. The method of any one of claims 2 to 10, further comprising forming an encapsulation on the topmost electrode of the layered electronic device (100).

12. The method of any one of claims 2 to 11, wherein each active layer is an electroactive layer.

13. The method of any one of claims 2 to 12, wherein the nanoparticles are elongated particles, preferably nanowires.

14. The method of any one of claims 3 to 13, wherein the film compressive yield strength is higher than the compressive yield strength of the substrate (110)

15. The method of any one of claims 4 to 14, wherein the film compressive yield strength is higher than the compressive yield strength of the active layer (130).

16. A layered electronic device (100) produced according to a method of any of the claims 1 to 15.

17. The layered electronic device (100) of claim 16, wherein the layered electronic device (100) is a haptic feedback actuator.

## Amended claims

### Amended claims in accordance with Rule 137(2) EPC.

1. A method for producing a layered electronic device (100) comprising a plurality of electrodes (120, 140), wherein at least one of the plurality of electrodes (120, 140) is a target electrode, the method comprising:
- providing a processing tool comprising a film providing a pressing surface for pressing the target electrode against a layer underneath the target electrode, wherein the film comprises a film compressive yield strength;
- processing the target electrode by at least pressing the pressing surface against the target electrode, wherein the film compressive yield strength is higher than a compressive yield strength of the layer underneath the target electrode.

2. The method of claim 1, further comprising:
- providing a substrate (110);
- depositing a first electrode (120) of the plurality of electrodes (120, 140) on the substrate (110);
- depositing an active layer (130) on the first electrode (120);
- depositing a second electrode (140) of the plurality of electrodes (120, 140) on the active layer (130);
wherein the target electrode comprises nanoparticles.

3. The method of claim 2, wherein the target electrode is the first electrode (120) and the layer underneath is the substrate, wherein processing the target electrode is carried out before depositing the active layer (130), and wherein processing the target electrode comprises embedding the nanoparticles of the first electrode (120) at least partially in the substrate (110).

4. The method of claim 2, wherein the target electrode is the second electrode (140) and the layer underneath is the active layer (130) and wherein processing the target electrode comprises embedding the nanoparticles of the second electrode (140) at least partially in the active layer (130).

5. The method of any one of claims 2 to 4, wherein the active layer (130) is a first active layer, the plurality of electrodes comprises a third electrode, and the method further comprises:
- depositing a second active layer on the second electrode (140); and
- depositing the third electrode on the second active layer.

6. The method of claim 5, wherein the third electrode comprises nanoparticles, the third electrode being the target electrode or a further target electrode, and the processing the third electrode comprises embedding the third electrode (140) at least partially in the second active layer (140).

7. The method of any one of claims 1 to 6, wherein the processing tool is a press and the pressing surface, which is provided by the film, is a press die surface.

8. The method of any one of claims 1 to 7, wherein a pressure applied by the pressing surface is selected from 10 MPa to 150 MPa.

9. The method of any one of claims 1 to 8, further comprising heating the at least partially produced layered electronic device.

10. The method of any one of claims 1 to 9, wherein heating is applied during pressing the pressing surface against the target electrode.

11. The method of any one of claims 1 to 10, wherein the surface of the pressing surface has a roughness lower than the roughness of the layer underneath.

12. The method of any one of claims 2 to 11, further comprising forming an encapsulation on the topmost electrode of the layered electronic device (100).

13. The method of any one of claims 2 to 12, wherein each active layer is an electroactive layer comprising an electroactive material, which is a material that undergoes shape change in response to an applied electrical field.

14. The method of any one of claims 2 to 13, wherein the nanoparticles are elongated particles, preferably nanowires.

15. The method of any one of claims 3 to 14, wherein the film compressive yield strength is higher than the compressive yield strength of the substrate (110)

16. The method of any one of claims 4 to 15, wherein the film compressive yield strength is higher than the compressive yield strength of the active layer (130).

17. The method of any one of claims 1 to 16, wherein the layered electronic device (100) is a haptic feedback actuator.
